# EUROPÄISCHE PATENTSCHRIFT

(11) **EP 2 807 285 B1**
(45) Veröffentlichungstag und Bekanntmachung des Hinweises auf die Patenterteilung: **14.08.2019**
(21) Anmeldenummer: 13700510.4
(22) Anmeldetag: 08.01.2013
(51) Int. Cl.: C23C 16/26, C23C 16/453, C23C 16/513, F24C 7/08, F24C 15/10

(54) **BAUTEIL FÜR EIN HAUSHALTSGERÄT**
COMPONENT FOR A HOUSEHOLD APPLIANCE
COMPOSANT POUR APPAREIL ÉLECTROMÉNAGER

(30) Priorität: 24.01.2012 DE 102012200969
(43) Veröffentlichungstag der Anmeldung: 03.12.2014
(73) Patentinhaber: BSH Hausgeräte GmbH, 81739 München (DE)
(72) Erfinder: JÖRDENS, Frank, 83278 Traunstein (DE); SALOMON, Jürgen, 83308 Trostberg (DE); SCHALLER , Philipp, 83301 Traunreut (DE); SCHMIDMAYER ,Gerhard, 83093 Bad Endorf (DE)
(86) Internationale Anmeldenummer: PCT/EP2013/050208
(87) Internationale Veröffentlichungsnummer: WO 2013/110491

(56) Entgegenhaltungen:
- EP-A1- 1 508 525
- WO-A1-2010/001949
- DE-U1- 20 106 167
- US-A- 5 691 010
- US-A1- 2004 147 191
- US-A1- 2011 122 486
- L. MARCINAUSKAS, A. GRIGONIS, P. VALATKEVICIUS, V. SABLINSKAS: SPIE, PO BOX 10 BELLINGHAM WA 98227-0010 USA, Bd. 6596, 1. Januar 2007 (2007-01-01), XP040241561,

## Beschreibung

Die Erfindung betrifft ein Bauteil für ein Haushaltsgerät, ein Haushaltsgerät mit einem derartigen Bauteil sowie ein Verfahren zum Herstellen eines solchen Bauteils für ein Haushaltsgerät.

Bedien-, Anzeige- und Gebrauchsoberflächen von Haushaltsgeräten bestehen je nach Anwendungszweck aus unterschiedlichen Materialien wie etwa Stahl, Glas, Glaskeramik oder Kunststoff und werden regelmäßig mit den Fingern berührt. Beispielsweise kombinieren berührungssensitive Bedienvorrichtungen von auch als "weiße Ware" bezeichneten elektrischen Haushaltsgeräten eine Anzeige- mit einer Bedienfunktion. Werden derartige Bauteiloberflächen im täglichen Gebrauch verwendet, so hinterlassen bereits leichte Berührungen unansehnliche Fingerabdrücke. Diese Fingerabdrücke bestehen größtenteils aus Hauttalg, Natriumchlorid und sonstigen Schweißrückständen und sind je nach Lichteinfall und Betrachterwinkel als helle oder dunkle Flecken auf der Bauteiloberfläche erkennbar. Ein heller Eindruck resultiert dabei aus der gerichteten Reflexion der Lichtstrahlen auf der verschmutzten Bauteiloberfläche; ein dunkler Eindruck entsteht durch die Brechung der Lichtstrahlen durch die Fingerabdruckverschmutzung hindurch. Darüber hinaus wird durch derartige Verschmutzungen die Sicht- und Lesbarkeit von Symbolen oder Bedienungselementen des Haushaltsgeräts eingeschränkt.

Neben der geschilderten Verschmutzungsproblematik durch Fingerabdrücke können Bauteiloberflächen im Bedien-, Sicht- und Gebrauchsbereich von Haushaltsgeräten aber auch durch Kontakt mit Lebensmitteln, Geschirr, Kleidung und dergleichen verschmutzen und müssen regelmäßig gereinigt werden. Darüber hinaus werden verschiedene Bauteiloberflächen in Haushaltsgeräten durch mechanische, thermische oder chemische Einflüsse während der Verwendung des betreffenden Haushaltsgeräts teilweise stark beansprucht und müssen entsprechend geschützt werden. Um Bauteiloberflächen von Haushaltsgeräten zu schützen, werden die entsprechenden Bauteile daher üblicherweise mit organischen Lacken auf Polyester- oder Acrylat-Basis oder mit Sol-Gel-Lacken auf der Basis silizium-organischer Verbindungen beschichtet. Die hierbei erforderlichen Schichtstärken zwischen etwa 5 µm und etwa 250 µm beeinträchtigen jedoch im Allgemeinen die optischen und haptischen Eigenschaften der Bauteiloberflächen vergleichsweise stark. Beispielsweise wird die Transparenz von durchsichtigen Bauteilen durch derartige Beschichtungen erheblich verringert. Darüber hinaus treten verschiedene substratspezifische Nachteile auf. So kommt es beispielsweise bei der so genannten Coil-Coating-Lackierung von Stahl bei nachfolgenden Umformungen häufig zu einem Aufreißen oder sogar Ablösen der aufgebrachten Beschichtungen. Dies führt neben verschlechterten optischen Eigenschaften auch zu einer erhöhten Korrosionsgefahr. Bei Bauteilen aus Glas führt ein Einbrennen der verwendeten Lacke bei Temperaturen zwischen 350 °C und 500 °C teilweise zu einem Verlust der Vorspannung des Glases, was im Hinblick auf eine mögliche Bruchgefahr als nachteilig anzusehen ist. Bei einem Beschichten von Bauteilen aus Glaskeramik reicht die Abrasionsfestigkeit der üblicherweise verwendeten Lacke bei weitem nicht an diejenige des Originalsubstrates heran, sodass diese Bauteile vergleichsweise schnell verkratzen. Bauteile aus Kunststoff können demgegenüber aufgrund der vergleichsweise geringen Temperaturbeständigkeit dieser Substrate nur sehr eingeschränkt beschichtet und dementsprechend schlecht vor Umwelteinflüssen geschützt werden.

In der WO 2010/001949 A1 werden abriebfeste Beschichtungen beschrieben, die unter anderem für elektrische Hausgeräte eingesetzt werden können. Eine auch als Diamond Like Carbon bezeichnete Schicht aus amorphen Kohlenstoff wird hierbei auf ein Werkstück aufgetragen.

Die DE 201 06 167 U1 beschreibt ein Kochfeld mit einer Glaskeramikplatte als Kochfläche, welche auf Ihre Oberseite eine Schutzschicht mit einer gegenüber der Glaskeramik erhöhten Kratzfestigkeit besitzt. Diese Schutzschicht kann dabei auch aus diamantartigem Kohlenstoff bestehen.

Die EP 1 508 525 A1 beschreibt einen Plastikbehälter, insbesondere eine PET-Flasche, welcher an seiner Innenseite mit einem diamantartigen Kohlenstoff beschichtet ist.

Die US 2011/0122486 A1 beschreibt eine Mehrschichtsystem auf einem Substrat, welches mit einem Plasmaverfahren aufgebracht wird. Dabei dient die Mehrlagenschicht als Diffusionssperre insbesondere für biokompatible Materialen.

Die US 2004/147191 A1 beschreibt ein Komposittextil oder Kompositmaterial mit einer Diamantbeschichtung. Auch hier kommt ein Plasmaverfahren zum Einsatz, um die Beschichtung auf das Textil/Material aufzubringen.

In dem Fachartikel "Formation of carbon coatings employing plasma torch from argonacetylene gas mixture" von L. Marcinauskas et al., erschienen bei den Proceedings of SPIE, Volume 6596, wird eine amorphe Kohlenstoffschicht auf einem Silizium Wafer aufgebracht.

Aufgabe der vorliegenden Erfindung ist es, ein Bauteil für ein Haushaltsgerät zu schaffen, welches eine Bauteiloberfläche mit verbesserten physikalischen und chemischen Eigenschaften aufweist. Eine weitere Aufgabe der vorliegenden Erfindung ist es, ein Haushaltsgerät mit einem derartigen Bauteil sowie ein Verfahren zum Herstellen eines derartigen Bauteils für ein Haushaltsgerät zu schaffen.

Die Aufgaben werden erfindungsgemäß durch ein Haushaltsgerät mit den Merkmalen des Patentanspruchs 1 sowie durch ein Verfahren zum Herstellen eines Bauteils für ein Haushaltsgerät mit den Merkmalen des Patentanspruchs 10 gelöst. Vorteilhafte Ausgestaltungen mit zweckmäßigen Weiterbildungen der Erfindung sind in den jeweiligen Unteransprüchen angegeben, wobei vorteilhafte Ausgestaltungen des Bauteils als vorteilhafte Ausgestaltungen des Verfahrens und umgekehrt anzusehen sind.

Ein Bauteil für ein Haushaltsgerät, welches eine Bauteiloberfläche mit verbesserten physikalischen und chemischen Eigenschaften aufweist, ist erfindungsgemäß dadurch geschaffen, dass das Bauteil zumindest bereichsweise mit einer amorphen Kohlenstoffschicht beschichtet ist. Amorphe Kohlenstoffschichten sind dünne Schichten, die je nach Ausgestaltung ausschließlich aus dem chemischen Element Kohlenstoff bestehen oder auf diesem Element basieren. Amorphe Kohlenstoffschichten erlauben dabei die Herstellung von Bauteilen für Haushaltsgeräte mit einer physikalisch und chemisch stabilen, fest haftenden und extrem dünn herstellbaren Beschichtung. Dabei kann grundsätzlich vorgesehen sein, dass nur ein Teilbereich des Bauteils oder dass das gesamte Bauteil mit der amorphen Kohlenstoffschicht beschichtet ist. Amorphe Kohlenstoffschichten können durch geeignete Wahl des Beschichtungsverfahrens sowie durch geeignete Prozessparameter in ihren Eigenschaften gezielt verändert und eingestellt werden. Die Beschichtung des Bauteils mit der amorphen Kohlenstoffschicht ermöglicht somit eine flexible Herstellung von Bauteilen mit Bauteiloberflächen, die grundsätzlich verschmutzungsabweisend, verschleißhemmend, leicht reinigbar, kratzfest, temperaturstabil, unter üblichen Betriebsbedingungen von Haushaltsgeräten chemisch inert, glatt, wasserabweisend und korrosionshemmend für Metalle sind. Die geringe erforderliche Dicke sowie die in gewissen Grenzen einstellbare Verformbarkeit der Beschichtung führen zudem zu einer guten Umformbeständigkeit von beschichteten Bauteilen aus umformbaren Materialien. Aufgrund der geringen erforderlichen Dicke der Beschichtung wird vorteilhaft ein Aufreißen der Beschichtung bei einer späteren Verformung des Bauteils und eine damit verbundene erhöhte Korrosionsgefahr zuverlässig verhindert. Aufgrund der geringen erforderlichen Dicken kann die amorphe Kohlenstoffschicht zudem mit sehr geringem Energieeintrag auf das Bauteil aufgebracht sein, so dass auch Bauteile aus temperaturempfindlichen Materialien wie beispielsweise vorgespanntem Glas oder Kunststoff problemlos mit der Beschichtung versehen werden können. Darüber hinaus kann das Bauteil in Abhängigkeit seines späteren Verwendungszwecks im Haushaltsgerät mit einer besonders dünnen Beschichtung versehen sein, die durch eine geeignete Brechzahlanpassung mit einer so genannten "Antifingerprint-Eigenschaft" versehen sein kann. Mit anderen Worten kann die amorphe Kohlenstoffschicht derart ausgebildet sein, dass Fingerabdrücke auf der Bauteiloberfläche des Bauteils optisch nicht erkennbar sind. Die amorphe Kohlenstoffschicht des erfindungsgemäßen Bauteils kann somit optimal an den jeweiligen Einsatzzweck des Bauteils angepasst werden, wodurch das Bauteil besonders flexibel im Bedien-, Sicht- und Gebrauchsbereich von Haushaltsgeräten verwendet werden kann.

Dabei ist vorgesehen, dass die amorphe Kohlenstoffschicht eine ortsabhängige Schichtzusammensetzung aufweist. Mit anderen Worten ist vorgesehen, dass die Struktur und molekulare Zusammensetzung der amorphen Kohlenstoffschicht innerhalb der Beschichtung variiert. Beispielsweise kann die amorphe Kohlenstoffschicht einen kontinuierlichen Schichtgradienten zwischen einem Bereich mit graphitartiger und einem Bereich mit diamantartiger Struktur, einem wasserstofffreien Bereich und einem wasserstoffhaltigen Bereich, Bereichen mit unterschiedlichen Wasserstoffgehalten, einem undotierten Bereich und einem Bereich mit Dotierungen etc. aufweisen. Weiterhin kann vorgesehen sein, dass die amorphe Kohlenstoffschicht eine unstetig und/oder mehrfach variierende Schichtzusammensetzung besitzt. Hierdurch können die Eigenschaften der Beschichtung besonders präzise an den jeweiligen Einsatzzweck des Bauteils angepasst werden.

In einer vorteilhaften Ausgestaltung der Erfindung ist vorgesehen, dass die amorphe Kohlenstoffschicht durch Beschichtung mittels eines atmosphärischen Plasmafreistrahls erzeugt wird. Hierbei wird bei Atmosphärendruck ein geeigneter kohlenstoffbasierter Werkstoff mit Hilfe eines Plasmastrahls auf die zu beschichtende Oberfläche des Bauteils aufgebracht. Der Werkstoff dissoziiert dabei aufgrund der hohen Temperatur im Plasma. Als Werkstoff können beispielsweise so genannte Precursormoleküle wie Methan, Acetylen, aromatische Kohlenwasserstoffe, Graphitpulver und dergleichen verwendet werden. Die dissoziierten Atome und Molekülfragmente polymerisieren dann auf der Bauteiloberfläche des Bauteils und bilden die festhaftende amorphe Kohlenstoffschicht. Zur Erzeugung eines Plasmas kann in einem an sich bekannten Plasmabrenner durch eine Hochfrequenzzündung ein Lichtbogen zwischen einer Kathode und einer Anode erzeugt werden. Bei entsprechend gewählter Zufuhr an Werkstoff bildet sich ein Plasmastrahl, der mit hoher Geschwindigkeit gebündelt aus einer Düse des Plasmabrenners ausströmt. Als Plasmafreistrahl definiert man das von der Düse des Plasmabrenners abströmende, stromfreie Plasma. Durch Variierung von Prozessparametern wie beispielsweise Precursorart und -konzentration, Temperatur, Druck, Plasmabrennergeometrie, Wahl zusätzlicher Prozessgase, Sauerstoffgehalt, Durchflussmenge, Abstand zum beschichteten Bauteil, Anregungsenergie etc. kann die amorphe Kohlenstoffschicht in ihren Eigenschaften gezielt verändert werden. Mit Hilfe von bewegbaren Düsen erhält man eine richtbare Plasmaquelle, so dass auch Bauteile mit komplexer Bauteilgeometrie problemlos, mit stark begrenzter lokaler Einwirkung und geringem Energieeintrag schnell und kostengünstig beschichtet werden können. Neben einer vergleichsweise preiswerten Anlagentechnik kann das Beschichten mittels atmosphärischem Plasmafreistrahl zudem besonders einfach in bereits bestehende Fertigungsabläufe (In-Line-Verfahren) integriert werden. Somit ergeben sich deutliche Kostenvorteile durch geringe Taktzeiten und leichte Skalierbarkeit. Demgegenüber sind beispielsweise Niederdruck-Plasma-Beschichtungsverfahren aufgrund der erforderlichen Evakuierung des Beschichtungsraumes schon aus Kostengründen nicht für eine Serienfertigung von Bauteilen für Haushaltsgeräte geeignet.

In einer weiteren vorteilhaften Ausgestaltung der Erfindung ist vorgesehen, dass die amorphe Kohlenstoffschicht zumindest bereichsweise graphitartig und/oder diamantartig ausgebildet ist. Graphitartige amorphe Kohlestoffschichten zeichnen sich durch überwiegend sp²-hybridisierte Kohlenstoff-Bindungen aus und besitzen daher zumindest überwiegend eine hexagonal flächige Struktur, welche für die graphitartigen Eigenschaften verantwortlich ist. Graphitartige amorphe Kohlenstoffschichten sind generell sehr glatt und weisen insbesondere einen sehr geringen Haftreibungskoeffizienten auf. Hierdurch schützen sie die darunter liegende und in der Regel rauere Bauteiloberfläche. Umgekehrt liegen in diamantartigen amorphen Kohlenstoffschichten überwiegend sp³-hybridisierte Kohlenstoff-Bindungen vor. Diamantartige amorphe Kohlenstoffschichten weisen daher eine zumindest überwiegend tetragonale Struktur auf, welche für die diamantartigen Eigenschaften verantwortlich ist. Diamantartige amorphe Kohlenstoffschicht zeichnet sich insbesondere durch einen hohen elektrischen Widerstand, extreme Härte und optische Transparenz aus. Der Übergang zwischen graphitartigen amorphen Kohlenstoffschichten und diamantartigen amorphen Kohlenstoffschichten ist fließend und kann durch geeignete Prozessparameter gezielt eingestellt werden.

Weitere Vorteile ergeben sich, wenn die amorphe Kohlenstoffschicht zumindest bereichsweise wasserstofffrei und/oder wasserstoffhaltig ausgebildet ist. Auch hierdurch können die Eigenschaften der amorphen Kohlenstoffschicht insbesondere durch die Wahl wasserstoffhaltiger oder wasserstofffreier Werkstoffe während der Herstellung einfach und gezielt eingestellt werden. Wasserstofffreie, amorphe, graphitartige Kohlenstoffschichten können dabei mit "a-C", wasserstofffreie, amorphe, diamantartige Kohlenstoffschichten mit "ta-C", wasserstoffhaltige, amorphe, graphitartige Kohlenstoffschichten mit "a-C:H" und wasserstoffhaltige, amorphe, diamantartige Kohlenstoffschichten mit "ta-C:H" abgekürzt werden. Wasserstoffhaltige amorphe Kohlenstoffschichten können darüber hinaus auch als amorphe Kohlenwasserstoffschichten bezeichnet werden.

Dabei hat es sich in weiterer Ausgestaltung als vorteilhaft gezeigt, wenn die amorphe Kohlenstoffschicht in einem wasserstoffhaltigen Bereich einen Wasserstoffanteil zwischen 20 % und 80 % aufweist, da dies eine einfache Einstellung der amorphen Kohlen(wasser)stoffschicht zwischen den Extremen "vollständig graphitartig" und "vollständig diamantartig" erlaubt. Unter einem Wasserstoffanteil zwischen 20% und 80% sind insbesondere Wasserstoffanteile von 20 %, 21 %, 22 %, 23 %, 24 %, 25 %, 26 %, 27 %, 28 %, 29 %, 30 %, 31 %, 32 %, 33 %, 34 %, 35 %, 36 %, 37 %, 38 %, 39 %, 40 %, 41 %, 42 %, 43 %, 44 %, 45 %, 46 %, 47 %, 48 %, 49 %, 50 %, 51 %, 52 %, 53 %, 54 %, 55 %, 56 %, 57 %, 58 %, 59 %, 60 %, 61 %, 62 %, 63 %, 64 %, 65 %, 66 %, 67 %, 68 %, 69 %, 70 %, 71 %, 72 %, 73 %, 74 %, 75 %, 76 %, 77 %, 78 %, 79 % oder 80 % sowie entsprechende Zwischenwerte zu verstehen. Ein molarer Wasserstoffgehalt zwischen etwa 60 % und etwa 80 % führt dabei generell zu einer eher graphitartigen Struktur der amorphen Kohlen(wasser)stoffschicht, während ein Wasserstoffgehalt von höchstens 30% generell zu einer eher diamantartigen Struktur der amorphen Kohlenstoffschicht führt. Die genaue Struktur der amorphen Kohlenstoffschicht hängt jedoch grundsätzlich von den konkret verwendeten Herstellungsbedingungen ab.

Die physikalischen und chemischen Eigenschaften der Beschichtung können in weiterer Ausgestaltung besonders einfach an den jeweiligen Einsatzzweck des Bauteil angepasst werden, indem die amorphe Kohlenstoffschicht zumindest bereichsweise metallhaltig und/oder durch Dotierung modifiziert ausgebildet ist. Durch das Beimischen von Metallen bzw. das Dotieren mit Metallen bildet sich in Abhängigkeit davon, ob die amorphe Kohlenstoffschicht wasserstofffrei, wasserstoffhaltig, graphitartig und/oder diamantartig ausgebildet ist, ein Verbund aus einer a-C/a-C:H/ta-C/ta-C:H Matrix und Metallkarbiden. Metallhaltige amorphe Kohlenstoffschichten, die in Abhängigkeit ihrer Ausgestaltung mit "a-C:Me/a-C:H:Me/ta-C:Me/ta-C:H:Me" abgekürzt werden, besitzen grundsätzlich eine besonders hohe Verschleißfestigkeit, geringe Reibkoeffizienten sowie eine zusätzlich verbesserte Haftung der Beschichtung auf bestimmten Materialien. Durch Veränderung des Metalls und des Metallgehaltes lassen sich die Materialeigenschaften der Beschichtung relativ stark beeinflussen. Alternativ oder zusätzlich können amorphe Kohlenstoffschichten auch durch Dotierung mit Elementen wie beispielsweise Si, O, N, F und B stark modifiziert werden. Silizium beispielsweise erhöht generell die Temperaturbeständigkeit der Beschichtung in sauerstoffhaltiger Umgebung. Eine Dotierung mit Silizium und Sauerstoff kann die Oberflächenspannung bis hin zu Werten in der Größenordnung von Polytetrafluorethylen herabsetzen. Außerdem lassen sich durch eine Dotierung hochtransparente und äußerst kratzfeste Schichten herstellen. Dotierte amorphe Kohlenstoffschichten werden in Abhängigkeit ihrer konkreten Ausgestaltung mit "a-C:X/a-C:H:X/ta-C:X/ta-C:H:X" abgekürzt, wobei X für das jeweils verwendete Dotierungselement steht.

Weitere Vorteile ergeben sich, indem die amorphe Kohlenstoffschicht eine Schichtdicke von mindestens 5 nm, insbesondere von mindestens 10 nm und/oder von höchstens 2000 nm, insbesondere von höchstens 500 nm aufweist. Unter einer Schichtdicke von mindestens 5 nm und/oder höchstens 2000 nm sind insbesondere Schichtdicken von 5 nm, 10 nm, 20 nm, 30 nm, 40 nm, 50 nm, 60 nm, 70 nm, 80 nm, 90 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 310 nm, 320 nm, 330 nm, 340 nm, 350 nm, 360 nm, 370 nm, 380 nm, 390 nm, 400 nm, 410 nm, 420 nm, 430 nm, 440 nm, 450 nm, 460 nm, 470 nm, 480 nm; 490 nm, 500 nm, 510 nm, 520 nm, 530 nm, 540 nm, 550 nm, 560 nm, 570 nm, 580 nm, 590 nm, 600 nm, 610 nm, 620 nm, 630 nm, 640 nm, 650 nm, 660 nm, 670 nm, 680 nm, 690 nm, 700 nm, 710 nm, 720 nm, 730 nm, 740 nm, 750 nm, 760 nm, 770 nm, 780 nm, 790 nm, 800 nm, 810 nm, 820 nm, 830 nm, 840 nm, 850 nm, 860 nm, 870 nm, 880 nm, 890 nm, 900 nm, 910 nm, 920 nm, 930 nm, 940 nm, 950 nm, 960 nm, 970 nm, 980 nm, 990 nm, 1000 nm, 1010 nm, 1020 nm, 1030 nm, 1040 nm, 1050 nm, 1060 nm, 1070 nm, 1080 nm, 1090 nm, 1100 nm, 1110 nm, 1120 nm, 1130 nm, 1140 nm, 1150 nm, 1160 nm, 1170 nm, 1180 nm, 1190 nm, 1200 nm, 1210 nm, 1220 nm, 1230 nm, 1240 nm, 1250 nm, 1260 nm, 1270 nm, 1280 nm, 1290 nm, 1300 nm, 1310 nm, 1320 nm, 1330 nm, 1340 nm, 1350 nm, 1360 nm, 1370 nm, 1380 nm, 1390 nm, 1400 nm, 1410 nm, 1420 nm, 1430 nm, 1440 nm, 1450 nm, 1460 nm, 1470 nm, 1480 nm, 1490 nm, 1500 nm, 1510 nm, 1520 nm, 1530 nm, 1540 nm, 1550 nm, 1560 nm, 1570 nm, 1580 nm, 1590 nm, 1600 nm, 1610 nm, 1620 nm, 1630 nm, 1640 nm, 1650 nm, 1660 nm, 1670 nm, 1680 nm, 1690 nm, 1700 nm, 1710 nm, 1720 nm, 1730 nm, 1740 nm, 1750 nm, 1760 nm, 1770 nm, 1780 nm, 1790 nm, 1800 nm, 1810 nm, 1820 nm, 1830 nm, 1840 nm, 1850 nm, 1860 nm, 1870 nm, 1880 nm, 1890 nm, 1900 nm, 1910 nm, 1920 nm, 1930 nm, 1940 nm, 1950 nm, 1960 nm, 1970 nm, 1980 nm, 1990 nm oder 2000 nm sowie entsprechende Zwischenwerte wie beispielsweise 10 nm, 11 nm, 12 nm, 13 nm, 14 nm, 15 nm, 16 nm, 17 nm, 18 nm, 19 nm, 20 nm etc. zu verstehen. Für die meisten Anwendungsfälle haben sich Dünnschichten zwischen etwa 10 nm und etwa 500 nm als vorteilhaft gezeigt. Insbesondere weisen derartige Dünnschichten einerseits eine ausreichende physikalische und chemische Stabilität auf und ermöglichen andererseits eine einfache Brechzahlanpassung zur Herstellung von Niedrigenergieoberflächen mit "Antifingerprint-Eigenschaften" auf dem Bauteil. Die Schichtdicke kann beispielsweise durch die Menge des zugeführten Werkstoffs pro Zeiteinheit, die relative Geschwindigkeit zwischen Plasmafreistrahl und Oberfläche und die Anzahl der Übergänge eingestellt werden.

In einer weiteren vorteilhaften Ausgestaltung ist vorgesehen, dass das Bauteil als Komponente einer Bedienvorrichtung und/oder als Anzeigevorrichtung und/oder als Arbeitsplatte und/oder als Verkleidungsteil ausgebildet ist. Beispielsweise kann das Bauteil als Bedienblende, Schalter oder berührungssensitive Bedienoberfläche einer Bedienvorrichtung ausgebildet sein. Weiterhin kann das Bauteil eine Anzeigevorrichtung, beispielsweise ein LED- oder OLED-Display, eine Arbeitsplatte oder ein Innen- oder Außenverkleidungsteil eines Haushaltsgeräts sein. Hierdurch können die vorstehend genannten Vorteile der amorphen Kohlenstoffschicht besonders flexibel für verschiedene Bedien-, Sicht- und Gebrauchsbereiche von Haushaltsgeräten verwirklicht werden.

Die Vorteile der Erfindung kommen zum Tragen, wenn das Haushaltsgerät zum Zubereiten von Lebensmitteln oder zum Aufbewahren und/oder Konservieren von Lebensmitteln oder zum Pflegen von Wäschestücken ausgebildet ist. Beispielsweise kann das Hausgerät als Herd, insbesondere Induktionsherd oder Strahlungsherd, Backofen, Mikrowellenherd oder Dampfgarer ausgebildet sein. Ferner ist eine Ausgestaltung als Kühlschrank, Gefrierschrank, Spülmaschine, Waschmaschine und/oder Wäschetrockner denkbar.

Ein weiterer Aspekt der Erfindung betrifft ein Verfahren zum Herstellen eines Bauteils für ein Haushaltsgerät, wobei erfindungsgemäß vorgesehen ist, dass das Bauteil zumindest bereichsweise mit einer amorphen Kohlenstoffschicht beschichtet wird. Hierdurch weist das erfindungsgemäß hergestellte Bauteil eine Bauteiloberfläche mit verbesserten physikalischen und chemischen Eigenschaften auf. Dabei kann grundsätzlich vorgesehen sein, dass das Bauteil nur bereichsweise oder vollständig mit der amorphen Kohlenstoffschicht beschichtet wird. Weitere sich hieraus ergebenden Merkmale und deren Vorteile sind den entsprechenden Beschreibungen des erfindungsgemäßen Bauteils zu entnehmen.

Es ist vorgesehen, dass die Schichtzusammensetzung der amorphen Kohlenstoffschicht während des Beschichtens variiert wird. Dabei kann grundsätzlich vorgesehen sein, dass die Schichtzusammensetzung einmal oder mehrmals während des Beschichtens variiert wird. Beispielsweise kann eine amorphe Kohlenstoffschicht mit einem kontinuierlichen Schichtgradienten zwischen einem Bereich mit graphitartiger und einem Bereich mit diamantartiger Struktur, mit einem wasserstofffreien Bereich und einem wasserstoffhaltigen Bereich, mit Bereichen mit unterschiedlichen Wasserstoffgehalten, mit einem undotierten Bereich und einem Bereich mit Dotierungen etc. erzeugt werden. Weiterhin kann vorgesehen sein, dass die Schichtzusammensetzung der amorphen Kohlenstoffschicht diskontinuierlich variiert wird. Hierdurch können die Eigenschaften der Beschichtung besonders präzise an den jeweiligen Einsatzzweck des Bauteils angepasst werden.

In einer vorteilhaften Ausgestaltung der Erfindung ist vorgesehen, dass die amorphe Kohlenstoffschicht durch Beschichten mittels eines atmosphärischen Plasmafreistrahls hergestellt wird. Hierbei wird bei Atmosphärendruck ein geeigneter kohlenstoffbasierter Werkstoff mit Hilfe eines Plasmastrahls auf die zu beschichtende Oberfläche des Bauteils aufgebracht. Der Werkstoff dissoziiert dabei aufgrund der hohen Temperatur im Plasma. Als Werkstoff können beispielsweise so genannte Precursormoleküle wie Methan, Ethan, Ethen, Ethin, aromatische Kohlenwasserstoffe, Graphitpulver und dergleichen verwendet werden. Die dissoziierten Atome und Molekülfragmente polymerisieren dann auf der Bauteiloberfläche des Bauteils und bilden die festhaftende amorphe Kohlenstoffschicht. Zur Erzeugung eines Plasmas kann in einem an sich bekannten Plasmabrenner durch eine Hochfrequenzzündung ein Lichtbogen zwischen mindestens einer Kathode und mindestens einer Anode erzeugt werden. Bei entsprechend gewählter Zufuhr an Werkstoff bildet sich ein Plasmastrahl, der mit hoher Geschwindigkeit gebündelt aus einer Düse des Plasmabrenners ausströmt. Als Plasmafreistrahl definiert man das von der Düse des Plasmabrenners abströmende, stromfreie Plasma. Durch Variierung von Prozessparametern wie beispielsweise Precursorart und -konzentration, Temperatur, Druck, Plasmastrahlgeometrie, Wahl zusätzlicher Prozessgase, Sauerstoffgehalt, Durchflussmenge, Abstand zum beschichteten Bauteil, Anregungsenergie etc. kann die amorphe Kohlenstoffschicht in ihren Eigenschaften gezielt verändert werden. Mit Hilfe von bewegbaren Düsen erhält man eine richtbare Plasmaquelle, so dass auch Bauteile mit komplexer Bauteilgeometrie problemlos, mit stark begrenzter lokaler Einwirkung und geringem Energieeintrag schnell und kostengünstig beschichtet werden können. Neben einer vergleichsweise preiswerten Anlagentechnik kann das Beschichten mittels atmosphärischem Plasmafreistrahl zudem besonders einfach in bereits bestehende Fertigungsabläufe (In-Line-Verfahren) integriert werden. Somit ergeben sich deutliche Kostenvorteile durch geringe Taktzeiten und leichte Skalierbarkeit. Demgegenüber sind beispielsweise Niederdruck-Plasma-Verfahren aufgrund der erforderlichen Evakuierung des Beschichtungsraumes schon aus Kostengründen nicht für eine Serienfertigung von Bauteilen für Haushaltsgeräte geeignet.

In einer weiteren vorteilhaften Ausgestaltung der Erfindung ist vorgesehen, dass die amorphe Kohlenstoffschicht auf eine Bauteiloberfläche aufgebracht wird, die zumindest bereichsweise aus einem Metall, einer Metalllegierung, einem Glas, einer Glaskeramik, einer Keramik oder einem Kunststoff ausgebildet ist. Hierdurch kann die amorphe Kohlenstoffschicht unabhängig von der Materialgestaltung des Bauteils und damit besonders flexibel auf unterschiedlichste Bauteiloberflächen aufgebracht werden. Darüber hinaus besteht die Möglichkeit, Bauteile nachträglich mit der amorphen Kohlenstoffschicht zu versehen, so dass auch bereits vorhandene Bauteile "nachgerüstet" werden können.

Weitere Merkmale der Erfindung ergeben sich aus den Ansprüchen, den Ausführungsbeispielen sowie anhand der Zeichnungen. Die vorstehend in der Beschreibung genannten Merkmale und Merkmalskombinationen sowie die nachfolgend in den Ausführungsbeispielen genannten Merkmale und Merkmalskombinationen sind nicht nur in der jeweils angegebenen Kombination, sondern auch in anderen sinnvollen Kombinationen verwendbar, ohne den Rahmen der Erfindung zu verlassen. Dabei zeigen:
- Fig. 1: eine schematische Aufsicht eines als Kochfeld ausgebildeten Haushaltsgeräts mit einem erfindungsgemäßen Bauteil;
- Fig. 2: eine schematische Perspektivansicht eines als Backofen ausgebildeten Haushaltsgeräts mit einer alternativen Ausgestaltung des erfindungsgemäßen Bauteils; und
- Fig. 3: eine schematische Aufsicht eines Haushaltsgeräts mit einem Kochfeld und einem als Arbeitsplatte ausgebildeten Bauteil.

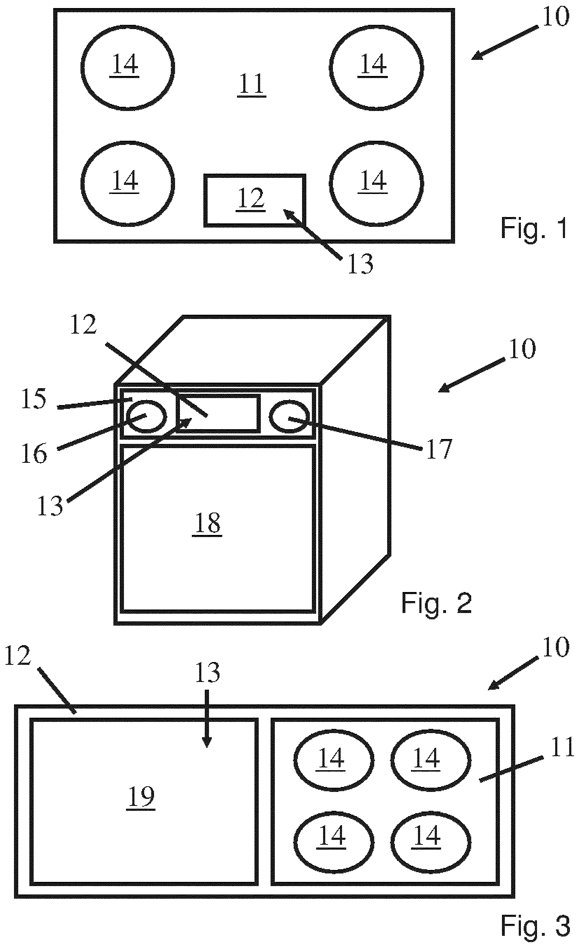

Fig. 1 zeigt eine schematische Aufsicht eines Haushaltsgeräts 10 mit einem erfindungsgemäßen Bauteil 12. Das Haushaltsgerät 10 umfasst ein Kochfeld 11 mit einer durchgehenden Oberfläche aus einer Glaskeramik, auf der in Position und Anzahl beispielhaft vier Kochzonen 14 markiert sind. Das Bauteil 12 ist in die durchgehende Oberfläche des Haushaltsgeräts 10 integriert und vorliegend als berührungssensitive Bedienvorrichtung (Touch-Sicht-Panel) ausgebildet. Das Bauteil 12 kombiniert somit eine Anzeige- mit einer Bedienfunktionalität des Haushaltsgeräts 10. Das Bauteil 12 weist an seiner freiliegenden Bauteiloberfläche eine wasserstoffhaltige amorphe Kohlenstoffschicht 13 auf, welche überwiegend graphitartig ausgebildet ist und daher mit "a-C:H" abgekürzt werden kann. Die wasserstoffhaltige amorphe Kohlenstoffschicht 13 wird durch Beschichten mittels atmosphärischem Plasmafreistrahl erzeugt. Hierzu wird bei Atmosphärendruck ein Plasma erzeugt, das wasserstoffhaltige Precursormoleküle wie beispielsweise Methan, Acetylen oder aromatische Kohlenwasserstoffe in hochreaktive Zustände überführt. Die gebildeten Molekülfragmente polymerisieren dann auf der Bauteiloberfläche und bilden die festhaftende amorphe Kohlenwasserstoffschicht a-C:H mit einer Schichtdicke zwischen 10 nm und 2000 nm. Die Eigenschaften der Beschichtung können durch geeignete Prozessparameter (Precursorart und - konzentration, Temperatur, Druck, Plasmastrahlgeometrie, etc.) in ihren Eigenschaften gezielt verändert werden. Insbesondere kann das Bauteil 12 vorteilhaft mit einer amorphen Kohlenwasserstoffschicht versehen werden, welche durch eine Brechzahlanpassung mit Antifingerprint-Eigenschaften versehen ist. Aufgrund der geringen Schichtdicke und des geringen Energieeintrags während des Beschichtens wird dabei die Vorspannung der Glaskeramik nicht beeinträchtigt. Alternativ kann vorgesehen sein, dass das gesamte Glaskeramik-Kochfeld bzw. die gesamte Oberfläche des Haushaltsgeräts 10 mit einer amorphen Kohlenstoffschicht 13 versehen ist. Weiterhin kann vorgesehen sein, dass unterschiedliche amorphe Kohlenstoffschichten 13 auf die Oberfläche des Haushaltsgeräts 10 aufgebracht sind. Beispielsweise können die Kochzonen 14 mit temperaturstabileren amorphen Kohlenstoffschichten 13 als das Bauteil 12 versehen sein. Alternativ oder zusätzlich kann die Struktur und Zusammensetzung der amorphen Kohlenstoffschicht 13 während des Beschichtens des Bauteils 12 bzw. des Haushaltsgeräts 10 ein- oder mehrfach variiert werden, um bestimmte Eigenschaften zu erzielen. Grundsätzlich kann jede Bedien-, Sicht- und Gebrauchsoberfläche von Haushaltsgeräten 10 aus Stahl, Glas, Glaskeramik, Kunststoff und dergleichen durch im Atmosphärendruckplasma abgeschiedene amorphe Kohlenstoffschichten 13 mit den Eigenschaften "fingerprintabweisend", "leicht reinigbar", "kratzfest", "temperaturstabil" und "korrosionshemmend" (für Stahl und dergleichen) ausgestattet werden.

Fig. 2 zeigt eine schematische Perspektivansicht eines als Backofen ausgebildeten Haushaltsgeräts 10 mit einer alternativen Ausgestaltung des erfindungsgemäßen Bauteils 12. Das Bauteil 12 ist dabei vorliegend als reine Anzeigevorrichtung ausgebildet und in eine Bedienblende 15 des Haushaltsgeräts 10 eingebettet. Weiterhin sind zwei Bedienelemente 16, 17 zur Einstellung der Backofenfunktionen an der Bedienblende 15 angeordnet. Die Bauteiloberfläche des Bauteils 12, von welcher verschiedene Betriebsparameter des Backofens ablesbar sind, ist vorliegend mit einer transparenten, tetraedrischen, wasserstofffreien, amorphen Kohlenstoffschicht 13 ("ta-C") beschichtet, wobei die Beschichtung eine Dicke von 100 nm besitzt. Zusätzlich kann vorgesehen sein, dass auch die Bedienblende 15 und/oder die Bedienelemente 16, 17 mit einer - gegebenenfalls abweichend ausgebildeten - amorphen Kohlenstoffschicht 13 versehen sind. Weiterhin kann vorgesehen sein, dass die Oberfläche eines Garraumes (nicht gezeigt) des Haushaltsgeräts 10 mit einer amorphen Kohlenstoffschicht 13 versehen ist, um beispielsweise ein Einbrennen von Lebensmittelresten zu verhindern und den Garraum leichter reinigbar zu machen. Entsprechend kann auch eine Backofentür 18 des Haushaltsgeräts 10 zumindest bereichsweise auf ihrer Innen- und/oder Außenseite mit einer amorphen Kohlenstoffschicht 13 versehen werden.

Fig. 3 zeigt eine schematische Aufsicht eines Haushaltsgeräts 10 mit einem Kochfeld 11 und einem als Arbeitsplatte ausgebildeten Bauteil 12. Das Kochfeld 11 umfasst mehrere Kochzonen 14 und ist in eine entsprechende Montageöffnung des Bauteils 12 eingelassen. Das Bauteil 12 umfasst weiterhin einen Arbeitsbereich 19, welcher mit einer amorphen Kohlenstoffschicht 13 versehen ist, die eine Schichtdicke von 800 nm aufweist. Der Arbeitsbereich 19 ist hierdurch besonders kratz- und schnittfest und besitzt eine sehr glatte Oberfläche. Daher kann der Arbeitsbereich 19 entsprechend leicht gereinigt werden und bietet besondere hygienische Vorteile.

### Bezugszeichenliste

- 10: Haushaltsgerät
- 11: Kochfeld
- 12: Bauteil
- 13: amorphe Kohlenstoffschicht
- 14: Kochzone
- 15: Bedienblende
- 16: Bedienelement
- 17: Bedienelement
- 18: Backofentür
- 19: Arbeitsbereich

## Patentansprüche

1. Haushaltsgerät (10) mit einem Bauteil (12) für ein Haushaltsgerät (10), wobei das Bauteil (12) zumindest bereichsweise mit einer amorphen Kohlenstoffschicht (13) beschichtet ist, **dadurch gekennzeichnet, dass** die amorphe Kohlenstoffschicht (13) eine ortsabhängig variierende Struktur und molekulare Zusammensetzung aufweist.

2. Haushaltsgerät (10) nach Anspruch 1, **dadurch gekennzeichnet, dass** die amorphe Kohlenstoffschicht (13) durch Beschichten mittels atmosphärischem Plasmafreistrahl erzeugt ist.

3. Haushaltsgerät (10) nach Anspruch 1 oder 2, **dadurch gekennzeichnet, dass** die amorphe Kohlenstoffschicht (13) zumindest bereichsweise graphitartig und/oder diamantartig ausgebildet ist.

4. Haushaltsgerät (10) nach einem der Ansprüche 1 bis 3, **dadurch gekennzeichnet, dass** die amorphe Kohlenstoffschicht (13) zumindest bereichsweise wasserstofffrei und/oder wasserstoffhaltig ausgebildet ist.

5. Haushaltsgerät (10) nach Anspruch 4, **dadurch gekennzeichnet, dass** die amorphe Kohlenstoffschicht (13) in einem wasserstoffhaltigen Bereich einen Wasserstoffanteil zwischen 20 % und 80 % aufweist.

6. Haushaltsgerät (10) nach einem der Ansprüche 1 bis 5, **dadurch gekennzeichnet, dass** die amorphe Kohlenstoffschicht (13) zumindest bereichsweise metallhaltig und/oder durch Dotierung modifiziert ausgebildet ist.

7. Haushaltsgerät (10) nach einem der Ansprüche 1 bis 6, **dadurch gekennzeichnet, dass** die amorphe Kohlenstoffschicht (13) eine Schichtdicke von mindestens 5 nm, insbesondere von mindestens 10 nm und/oder von höchstens 2000 nm, insbesondere von höchstens 500 nm aufweist.

8. Haushaltsgerät (10) nach einem der Ansprüche 1 bis 7, **dadurch gekennzeichnet, dass** dieses als Komponente einer Bedienvorrichtung und/oder als Anzeigevorrichtung und/oder als Arbeitsplatte und/oder als Verkleidungsteil ausgebildet ist.

9. Haushaltsgerät (10) nach einem der vorhergehenden Ansprüche, **dadurch gekennzeichnet, dass** dieses zum Zubereiten von Lebensmitteln oder zum Aufbewahren und/oder Konservieren von Lebensmitteln oder zum Pflegen von Wäschestücken ausgebildet ist.

10. Verfahren zum Herstellen eines Bauteils (12) für ein Haushaltsgerät (10), wobei das Bauteil (12) zumindest bereichsweise mit einer amorphen Kohlenstoffschicht (13) beschichtet wird, wobei die Schichtzusammensetzung der amorphen Kohlenstoffschicht (13) während des Beschichtens variiert wird, indem die amorphe Kohlenstoffschicht zumindest bereichsweise graphitartig und/oder diamantartig und/oder wasserstofffrei und/oder wasserstoffhaltig und/oder metallhaltig und/oder durch Dotierung modifiziert ausgebildet wird, sodass die amorphe Kohlenstoffschicht (13) mit einer ortsabhängig variierenden Struktur und molekularen Zusammensetzung erzeugt wird.

11. Verfahren nach Anspruch 10, **dadurch gekennzeichnet, dass** die amorphe Kohlenstoffschicht (13) durch Beschichten mittels atmosphärischem Plasmafreistrahl hergestellt wird.

12. Verfahren nach Anspruch 10 oder 11, **dadurch gekennzeichnet, dass** die amorphe Kohlenstoffschicht (13) auf eine Bauteiloberfläche aufgebracht wird, die zumindest bereichsweise aus einem Metall, einer Metalllegierung, einem Glas, einer Glaskeramik, einer Keramik oder einem Kunststoff ausgebildet ist.

## Claims

1. Household appliance (10) with a component (12) for a household appliance (10), wherein the component (12) is coated at least in sections with an amorphous carbon layer (13), **characterised in that** the amorphous carbon layer (13) has a structure which varies depending on location and a molecular composition.

2. Household appliance (10) according to claim 1, **characterised in that** the amorphous carbon layer (13) is produced by coating using an atmospheric plasma free jet.

3. Household appliance (10) according to claim 1 or 2, **characterised in that** the amorphous carbon layer (13) is embodied at least in sections in a graphite- and/or diamondlike manner.

4. Household appliance (10) according to one of claims 1 to 3, **characterised in that** the amorphous carbon layer (13) is embodied at least in sections to be hydrogen-free and/or hydrogenous.

5. Household appliance (10) according to claim 4, **characterised in that** the amorphous carbon layer (13) has a hydrogen portion between 20% and 80% in a hydrogenous region.

6. Household appliance (10) according to one of claims 1 to 5, **characterised in that** the amorphous carbon layer (13) is embodied at least in sections to be metalliferous and/or to be modified by means of doping.

7. Household appliance (10) according to one of claims 1 to 6, **characterised in that** the amorphous carbon layer (13) has a layer thickness of at least 5 nm, in particular of at least 10 nm and/or of at most 2000 nm, in particular at most 500 nm.

8. Household appliance (10) according to one of claims 1 to 7, **characterised in that** this is embodied as a component of a control apparatus and/or as a display apparatus and/or as a worktop and/or as a cladding part.

9. Household appliance (10) according to one of the preceding claims, **characterised in that** this is embodied to prepare food or to preserve and/or conserve food or to care for laundry items.

10. Method for producing a component (12) for a household appliance (10), wherein the component (12) is coated at least in sections with an amorphous carbon layer (13), wherein the layer composition of the amorphous carbon layer (13) is varied during the coating, by the amorphous carbon layer being embodied at least in sections in a graphite- and/or diamondlike manner and/or to be hydrogen-free and/or hydrogenous and/or metalliferous and/or modified by means of doping, so that the amorphous carbon layer (13) is produced with a structure which varies depending on location and has a molecular composition.

11. Method according to claim 10, **characterised in that** the amorphous carbon layer (13) is produced by coating using atmospheric plasma free jet.

12. Method according to claim 10 or 11, **characterised in that** the amorphous carbon layer (13) is applied to a component surface, which is embodied at least in sections from a metal, a metal alloy, a glass, a glass ceramic, a ceramic or a plastic.

## Revendications

1. Appareil ménager (10) avec un composant (12) pour un appareil ménager (10), dans lequel le composant (12) est revêtu au moins par sections d'une couche de carbone amorphe (13), **caractérisé en ce que** la couche de carbone amorphe (13) présente une structure et une composition moléculaire variant en fonction de l'endroit.

2. Appareil ménager (10) selon la revendication 1, **caractérisé en ce que** la couche de carbone amorphe (13) est générée par revêtement au moyen d'un jet de plasma libre atmosphérique.

3. Appareil ménager (10) selon la revendication 1 ou 2, **caractérisé en ce que** la couche de carbone amorphe (13) est exécutée au moins par sections à la façon du graphite et/ou à la façon du diamant.

4. Appareil ménager (10) selon l'une des revendications 1 à 3, **caractérisé en ce que** la couche de carbone amorphe (13) est exécutée au moins par sections sans et/ou avec hydrogène.

5. Appareil ménager (10) selon la revendication 4, **caractérisé en ce que** la couche de carbone amorphe (13) présente dans une section contenant de l'hydrogène une teneur en hydrogène entre 20% et 80%.

6. Appareil ménager (10) selon l'une des revendications 1 à 5, **caractérisé en ce que** la couche de carbone amorphe (13) est exécutée au moins par sections avec du métal et/ou en étant modifiée par dotation.

7. Appareil ménager (10) selon l'une des revendications 1 à 6, **caractérisé en ce que** la couche de carbone amorphe (13) présente une épaisseur de couche minimale de 5 nm, en particulier minimale de 10 nm et/ou maximale de 2000 nm, en particulier maximale de 500 nm.

8. Appareil ménager (10) selon l'une des revendications 1 à 7, **caractérisé en ce que** celui-ci est exécuté sous forme de composant d'un dispositif de commande et/ou sous forme de dispositif d'affichage et/ou sous forme de plan de travail et/ou sous forme de pièce d'habillage.

9. Appareil ménager (10) selon l'une des revendications précédentes, **caractérisé en ce que** celui-ci est exécuté pour la préparation de denrées alimentaires ou pour la conservation de denrées alimentaires ou pour l'entretien du linge.

10. Procédé de fabrication d'un composant (12) pour un appareil ménager (10), dans lequel le composant (12) est revêtu au moins par sections d'une couche de carbone amorphe (13), dans lequel la composition de la couche de carbone amorphe (13) subit une variation durant le revêtement, en exécutant la couche de carbone amorphe au moins par sections à la façon du graphite et/ou à la façon du diamant et/ou sans hydrogène et/ou avec hydrogène et/ou avec du métal et/ou en étant modifiée par dotation, de sorte que la couche de carbone amorphe (13) est générée avec une structure et une composition moléculaire variant en fonction de l'endroit.

11. Procédé selon la revendication 10, **caractérisé en ce que** la couche de carbone amorphe (13) est fabriquée par revêtement au moyen d'un jet de plasma libre atmosphérique.

12. Procédé selon la revendication 10 ou 11, **caractérisé en ce que** la couche de carbone amorphe (13) est apposée sur une surface de composant exécutée au moins par sections en un métal, un alliage métallique, un verre, une vitrocéramique, une céramique ou un plastique.
